(19) Europäisches Patentamt
European Patent Office
Office européen des brevets

(11) **EP 2 530 737 B1**

(12) **EUROPEAN PATENT SPECIFICATION**

(45) Date of publication and mention
of the grant of the patent:
**17.04.2019 Bulletin 2019/16**

(51) Int Cl.:
***H01L 31/042*** *(2014.01)*

(21) Application number: **11737094.0**

(22) Date of filing: **27.01.2011**

(86) International application number:
**PCT/JP2011/051606**

(87) International publication number:
**WO 2011/093383 (04.08.2011 Gazette 2011/31)**

(54) **SOLAR CELL MODULE**

SOLARZELLENMODUL

MODULE DE CELLULES SOLAIRES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.01.2010 JP 2010018658**

(43) Date of publication of application:
**05.12.2012 Bulletin 2012/49**

(73) Proprietor: **Panasonic Intellectual Property
Management Co., Ltd.
Osaka-shi, Osaka 540-6207 (JP)**

(72) Inventors:
• **ISHIGURO, Tasuku
Moriguchi-shi
Osaka 570-8677 (JP)**
• **SAITA, Atsushi
Moriguchi-shi
Osaka 570-8677 (JP)**

(74) Representative: **Mewburn Ellis LLP
City Tower
40 Basinghall Street
London EC2V 5DE (GB)**

(56) References cited:
**JP-A- 2002 039 631     JP-A- 2003 258 283
JP-A- 2005 050 928     JP-A- 2008 235 603**

**Description**

Technical Field

This invention relates to a solar cell module. Particularly, this invention relates to a solar cell module including a solar cell disposed inside a filler layer provided between a plate and a sheet.

Background Art

Recently, great attention has been given to solar cell modules as an energy source with small load on an environment.

A solar cell module includes a solar cell that receives light to generate electric power. The solar cell is apt to be degraded by contact with moisture or the like. Consequently, there is a necessity to isolate the solar cell from outside air. Accordingly, the solar cell is typically disposed inside a filler layer provided between a plate and a sheet. That is, the solar cell is sealed with the filler layer.

Examples of a material for the filler layer may include an ethylene-vinyl acetate copolymer (EVA) as disclosed in Patent Literature 1 and the like. In the case of forming the filler layer from EVA, it is possible to decrease the moisture permeability of the filler layer and to increase the light transmittance of the filler layer. Accordingly, EVA is suitably used as the material for the filler layer.

JP2002039631 discloses a photothermal panel that is obtained by heating and pressurizing a laminate on which a rear-surface member (an integrally laminated body of three layers of an adhesive resin, a rear-surface insulator, and a rear-surface sealing resin), a photovoltaic element, and a surface member (an integrally laminated body of two layers of a surface sealing material and a surface light-transmissive film) are piled up on a solar heat collector formed by welding a planar metallic sheet, a corrugated metallic sheet, and upper and lower header pipes to each other by using the collector as a structural supporting body.

JP2005129926 discloses a crosslinking laminated sheet composed of a main body layer containing an ethylene-vinyl acetate copolymer containing vinyl acetate at a rate of 21-40 wt.% as the main ingredient, and a sealing layer containing an ethylene-vinyl acetate copolymer containing vinyl acetate at a rate of >=10 wt.% as the main ingredient and having a thickness of 0.2-1.2 mm. The laminated sheet is used as the sheet for a solar cell sealing medium.

JP2008235603 discloses a solar battery module in which solar cells are sealed by a sealing member between a transparent front surface protective member and a back surface protective member, wherein the sealing member includes at least a first sealing member and a second sealing member, which are different types, and the sealing member, exposed to a side surface of the solar cell module, is the first sealing member.

Citation List

Patent Literature

Patent Literature 1: JP 2005-129926 A

Summary

Technical Problem

Incidentally, the characteristic of EVA varies on the basis of a vinyl acetate content. For example, EVA having a large vinyl acetate content is apt to absorb moisture while EVA having a small vinyl acetate content is hard to absorb moisture. Consequently, in order to obtain a solar cell module which includes a filler layer having low moisture permeability and has excellent weatherability, there is a necessity to form the filler layer from EVA having a small vinyl acetate content.

However, EVA having a small vinyl acetate content has fluidity which is high at high temperature. Consequently, in the case of forming a filler layer from the EVA having a small vinyl acetate content, there is a possibility that the heat resistance of a solar cell module is degraded because the filler layer is flown when the solar cell module is heated to high temperature.

The present invention has been devised in view of the circumstances described above, and an object thereof is to provide a solar cell module which is excellent in both of weatherability and heat resistance.

Solution to Problem

As a result of the study eagerly conducted by the inventors of the present invention, it has been found that the heat resistance of a solar cell module is not degraded in the case where a predetermined condition is satisfied even when a part of a filler layer contains, as a main component, EVA having a small vinyl acetate content. Specifically, the inventors of the present invention have found that in a filler layer provided between a plate and a sheet, in the case where at least a part of a portion being in contact with the sheet contains, as a main component, EVA having a large vinyl acetate content or polyethylene containing no vinyl acetate unit, favorable heat resistance is achieved even when the remaining portion of the filler layer contains, as a main component, EVA having a small vinyl acetate content. As the result, the inventors of the present invention have devised the present invention.

Herein, the "vinyl acetate content" in the present invention refers to a vinyl acetate content based on JIS K7192:1999 (complying with ISO 8985). In the present invention, the vinyl acetate content can be measured in accordance with a saponifying method based on JIS K7192:1999 (complying with ISO 8985). Specifically, the vinyl acetate content can be measured in accordance with the following method. First, a sample is weighed by a predetermined amount. The amount of the sample to be weighed is set to 1 g in the case where the vinyl acetate content is less than 10% by mass, 0.5 g in the case of 10% by mass to 20% by mass, 0.3 g in the case of 20% by mass to 40% by mass, and 0.2 g in the case of not less than 40% by mass. Next, about 50 ml of xylene and 20 ml of a 0.1 N potassium hydroxide solution in ethanol are added to the weighed sample, and the resultant sample is refluxed at 200°C for 2 hours. After the reflux, 30 ml of a 0.1 N sulfuric acid aqueous solution is added to the cooled sample, and then the resultant sample is stirred. Thereafter, the volume of an excessive sulfuric acid solution in the resultant solution is titrated using a 0.1 N sodium hydroxide solution (Titration Test 1). Moreover, the titration test described above is conducted without adding a sample (Titration Test 2). Next, the vinyl acetate content is calculated from the following equation (1).

$$\text{Vinyl acetate content (\% by mass)} = \{(0.00869(A-B)\}/S) \times 100 \dots (1)$$

In this equation (1),
A represents the volume (ml) of the sulfuric acid aqueous solution determined as being excessive in Titration Test 1,
B represents the volume (ml) of the sulfuric acid aqueous solution determined as being excessive in Titration Test 2, and
S represents the mass (g) of the sample weighed in Titration Test 1.

In the present invention, the phrase "containing, as a main component, an ethylene-vinyl acetate copolymer" indicates that only an ethylene-vinyl acetate copolymer is contained or an additive such as a light stabilizer or an ultraviolet absorber or a resin other than the ethylene-vinyl acetate copolymer, such as a silane modified resin, is contained in a ratio within 5% by mass in the ethylene-vinyl acetate copolymer.

Moreover, the phrase "containing, as a main component, polyethylene" indicates that only polyethylene is contained or an additive such as a light stabilizer or an ultraviolet absorber or a resin other than the polyethylene, such as a silane modified resin, is contained in a ratio within 5% by mass in the polyethylene.

Statement of the invention

According to the present invention there is provided a solar cell module according to claim 1.

The solar cell module according to the present invention may optionally be as specified in any one of claims 2 to 15.

According to the present invention, it is possible to provide a solar cell module which is excellent in both of weatherability and heat resistance.

Brief Description of Drawings

Fig. 1 is a schematic sectional view of a solar cell module according to a first embodiment.
Fig. 2 is a schematic sectional view of a solar cell module according to a second embodiment.
Fig. 3 is a schematic sectional view of a solar cell module according to a third embodiment.
Fig. 4 is a schematic sectional view of a solar cell module according to a fourth embodiment.
Fig. 5 is a schematic sectional view of a solar cell module according to a fifth embodiment.
Fig. 6 is a schematic sectional view of a solar cell module according to a sixth embodiment.
Fig. 7 is a schematic sectional view of a solar cell module according to a seventh embodiment.
Fig. 8 is a schematic sectional view of a solar cell module according to an eighth embodiment.
Fig. 9 is a schematic sectional view of a solar cell module according to a ninth embodiment.

Fig. 10 is a schematic sectional view of a solar cell module according to a tenth embodiment.
Fig. 11 is a schematic sectional view of a solar cell module according to an eleventh embodiment.
Fig. 12 is a schematic sectional view of a solar cell module according to a twelfth embodiment.

Description of Embodiments

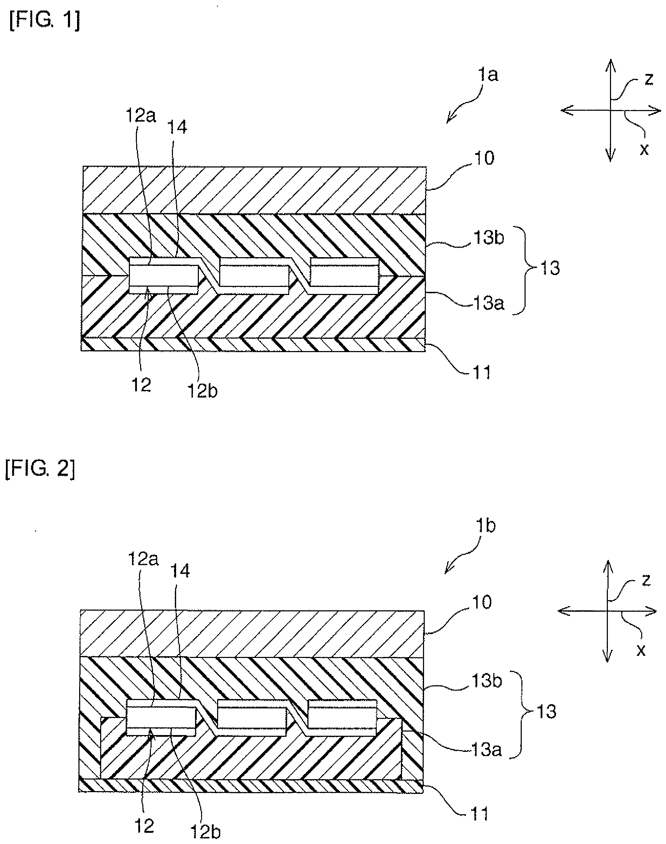

Preferred embodiments of the present invention will be described below with solar cell modules 1a to 11 in Figs. 1 to 12 each taken as an example. However, the solar cell modules 1a to 11 are merely illustrative. The present invention is not intended to be limited to the solar cell modules 1a to 11.

Throughout the respective drawings to be referred in the following embodiments, moreover, members having substantially identical functions are denoted with identical reference signs. Moreover, the drawings to be referred in the embodiments are schematically made, and the dimensional ratio and the like of a physical object depicted in the drawings occasionally differ from the dimensional ratio and the like of an actual physical object. The respective drawings occasionally differ from one another with regard to the dimensional ratio and the like of a physical object. The dimensional ratio and the like of a specific physical object should be determined in consideration of the following description.

<<First Embodiment>>

Fig. 1 is a schematic sectional view of a solar cell module according to the present embodiment.

As illustrated in Fig. 1, the solar cell module 1a includes a plate 10, a sheet 11, a filler layer 13 and a solar cell 12.

(Plate 10 and sheet 11)

The plate 10 and the sheet 11 each have a function as a protection member for the solar cell 12. The plate 10 is a member that ensures the mechanical strength of the solar cell module 1a. The plate 10 is not particularly limited as long as it is a rigid member. The plate 10 can be configured with a glass plate, a resin plate or the like. Particularly, it is preferred that the plate 10 is configured with a glass plate because of the following reason. That is, the glass plate has high rigidity and high light transmittance, and is excellent in weatherability.

Herein, a thickness of the plate 10 is not particularly limited. For example, the thickness of the plate 10 can be set to about 3 mm to 6 mm.

The sheet 11 is opposed to the plate 10. The sheet 11 is not particularly limited as long as it is a flexible member. For example, the sheet 11 can be configured with a resin sheet made of polyethylene terephthalate (PET) or the like. For example, a light shielding foil such as an aluminum foil, an inorganic barrier layer having low moisture permeability, or the like may be provided inside the resin sheet to be used as the sheet 11. For example, the inorganic barrier layer can be made of an inorganic oxide such as silicon oxide, aluminum oxide or magnesium oxide, or the like.

Herein, a thickness of the sheet 11 is not particularly limited. For example, the thickness of the sheet 11 can be set to about 150 $\mu$m to 300 $\mu$m.

The filler layer 13 is filled between the plate 10 and the sheet 11. The filler layer 13 is a member for sealing the solar cell 12. Therefore, the filler layer 13 is also called a sealing layer. A configuration of the filler layer 13 will be specifically described later.

(Solar cell 12)

The plurality of solar cells 12 is disposed inside the filler layer 13. The solar cells 12 are arranged along an arrangement direction x perpendicular to a lamination direction z of the plate 10, filler layer 13 and sheet 11. The solar cells 12 may be arranged in a matrix form on a plane in which the lamination direction z is defined as a normal direction.

The solar cells 12 are electrically connected to one another in series or in parallel using wiring members 14. For example, the solar cell 12 and the wiring member 14 can be bonded together using a conductive resin adhesive containing a resin and conductive particles dispersed in the resin, solder or the like.

In the present embodiment, each of the solar cells 12 is disposed to have a light receiving surface 12a directed to the plate 10 and a rear surface 12b directed to the sheet 11. That is, in the present embodiment, each of the solar cells 12 receives light entering from the plate 10. However, the present invention is not limited to this configuration. For example, the solar cell may be disposed to have the light receiving surface directed to the sheet and the rear surface directed to the plate. Moreover, each of both the main surfaces of the solar cell may be a light receiving surface.

A structure of the solar cell 12 is not particularly limited. For example, the solar cell 12 may be a HIT (registered trademark) solar cell having a HIT structure or may be a solar cell having a different structure.

Typically, the solar cell 12 includes a photoelectric conversion body that receives light, thereby generating carriers (electrons and positive holes). The photoelectric conversion body is made of a semiconductor material having a semiconductor junction such as a pn junction or a pin junction. Examples of the semiconductor material may include a crystalline silicon semiconductor such as single-crystalline silicon or polycrystalline silicon, an amorphous silicon semiconductor, a compound semiconductor such as GaAs, and the like.

The photoelectric conversion body has first and second main surfaces on which collector electrodes for collecting carriers are formed, respectively. The collector electrodes on the adjoining solar cells 12 are connected to each other using the wiring member 14, so that the respective solar cells 12 are electrically connected to one another. Typically, the collector electrode includes a plurality of fingers mutually extending in parallel, and one or a plurality of bus bars extending in a direction perpendicular to the direction of extension of the finger and connected to each of the fingers, but is not limited thereto.

(Filler layer 13)

Next, the configuration of the filler layer 13 in the present embodiment will be specifically described.

The filler layer 13 includes a first filler layer 13a and a second filler layer 13b.

The first filler layer 13a is provided to come into contact with the sheet 11. In the present embodiment, specifically, the first filler layer 13a and the second filler layer 13b are laminated in this order from the sheet 11 side in between the sheet 11 and the plate 10. The sheet 11 and the first filler layer 13a are bonded together. The first filler layer 13a and the second filler layer 13b are also bonded together. The second filler layer 13b and the plate 10 are also bonded together.

The solar cell 12 is disposed on a boundary between the first filler layer 13a and the second filler layer 13b. Therefore, the first filler layer 13a is in contact with the solar cell 12. For the convenience of depiction, Fig. 1 illustrates the boundary between the first filler layer 13a and the second filler layer 13b such that the boundary is placed inside a region where the solar cell 12 is provided in the lamination direction z. However, the boundary may be almost flush with the light receiving surface 12a or the rear surface 12b of the solar cell 12 in the lamination direction z, for example.

A thickness of each of the first filler layer 13a and the second filler layer 13b in the lamination direction z is not particularly limited. For example, it is preferred that the thickness of the first filler layer 13a in the lamination direction z is about 0.3 mm to 0.8 mm. For example, it is preferred that the thickness of the second filler layer 13b in the lamination direction z is about 0.3 mm to 0.8 mm. For example, it is preferred that the thickness of the entire filler layer 13 in the lamination direction z is about 0.6 mm to 2.0 mm. It is preferred that a ratio of the thickness of the first filler layer 13a in the lamination direction z and the thickness of the second filler layer 13b in the lamination direction z falls within a range of 1 : 2 to 2 : 1.

The first filler layer 13a contains, as a main component, an ethylene-vinyl acetate copolymer (EVA). The first filler layer 13a may be made of EVA, or may be made of a mixture or a copolymer of EVA and a different resin, or EVA to which an additive is added. Herein, examples of the different resin may include a silane modified resin and the like. Moreover, examples of the additive may include a light stabilizer, an ultraviolet absorber and the like.

The second filler layer 13b contains, as a main component, polyethylene containing no vinyl acetate unit. The second filler layer 13b may be made of polyethylene, or may be made of a mixture or a copolymer of polyethylene and a different resin, or polyethylene to which an additive is added.

Herein, examples of the different resin may include a silane modified resin and the like. Moreover, examples of the additive may include a light stabilizer, an ultraviolet absorber and the like.

In a non-claimed example where the second filler layer 13b contains EVA as a main component, a vinyl acetate content in the EVA contained in the second filler layer 13b is smaller than a vinyl acetate content in the EVA contained in the first filler layer 13a. The vinyl acetate content in the EVA contained in the first filler layer 13a is preferably not less than 1.5 times, more preferably not less than 2 times, further preferably not less than 5 times as large as the vinyl acetate content in the EVA contained in the second filler layer 13b. The vinyl acetate content in the EVA contained in the first filler layer 13a is preferably not less than 20% by mass, more preferably not less than 25% by mass. The vinyl acetate content in the EVA contained in the first filler layer 13a is preferably not more than 30% by mass. The vinyl acetate content in the EVA contained in the second filler layer 13b is preferably not more than 20% by mass, more preferably not more than 15% by mass, further preferably not more than 5% by mass.

As described above, in the present embodiment, provided is the second filler layer 13b which contains, as a main component, polyethylene having a vinyl acetate content of zero and has low moisture permeability. Therefore, in the solar cell module 1a according to the present embodiment, for example, an amount of moisture reaching the solar cell 12 is small as compared with the case where the filler layer includes only the first filler layer having a large vinyl acetate content. Therefore, it is possible to prevent the degradation of the solar cell 12 due to moisture. Accordingly, the solar cell module 1a achieves favorable weatherability.

In the present embodiment, further, the first filler layer 13a which contains, as a main component, EVA having a large vinyl acetate content and has fluidity which is low even at high temperature is provided to come into contact with the sheet 11 which is lower in rigidity than the plate 10. Therefore, it is possible to realize favorable heat resistance.

That is, it is possible to achieve both of favorable weatherability and favorable heat resistance in such a manner that the first filler layer 13a which contains, as a main component, the EVA having a large vinyl acetate content and has fluidity which is low at high temperature is provided to come into contact with the sheet 11 and, further, the second filler layer 13b which contains, as a main component, polyethylene and has low moisture permeability is provided as described in the present embodiment.

As a reason why heat resistance can be improved in such a manner that the first filler layer 13a containing, as a main component, the EVA having a large vinyl acetate content is provided to come into contact with the sheet 11, it is considered that in the first filler layer 13a on the sheet 11 which is lower in rigidity than the plate 10, the portion on the sheet 11 side can be prevented from being flown at high temperature . However, it is unsure why heat resistance can be considerably improved in such a manner that the first filler layer 13a is provided to come into contact with the sheet 11 although the second filler layer 13b having fluidity which is high at high temperature is provided.

In a non-claimed example where the vinyl acetate content in the EVA contained in the first filler layer 13a is not less than 1.5 times as large as the vinyl acetate content in the EVA contained in the second filler layer 13b, it is possible to achieve both of favorable weatherability and favorable heat resistance at higher level. The vinyl acetate content in the EVA contained in the first filler layer 13a is more preferably not less than 2 times, further preferably not less than 5 times as large as the vinyl acetate content in the EVA contained in the second filler layer 13b.

It is possible to achieve more favorable heat resistance in the case where the vinyl acetate content in the EVA contained in the first filler layer 13a is not less than 20% by mass, and to achieve further favorable heat resistance in the case of not less than 25% by mass.

However, if the vinyl acetate content in the EVA contained in the first filler layer 13a is too large, there is a possibility that the degradation is accelerated because a moisture content in the EVA becomes too large. Accordingly, it is preferred that the vinyl acetate content in the EVA contained in the first filler layer 13a is not more than 30% by mass.

In a non-claimed example, it is possible to achieve more preferable weatherability in the case where the vinyl acetate content in the EVA contained in the second filler layer 13b is not more than 20% by mass. The vinyl acetate content in the EVA contained in the second filler layer 13b is more preferably not more than 15% by mass, further preferably not more than 5% by mass. The vinyl acetate content in the EVA contained in the second filler layer 13b may be zero. In the present invention, the second filler layer 13b is made of polyethylene.

In the present embodiment, the first filler layer 13a having fluidity which is low at high temperature is provided to come into contact with the solar cell 12. Therefore, it is possible to realize more excellent heat resistance.

In the present embodiment, the plate 10 disposed on the light receiving surface 12a side of the solar cell 12 is configured with a glass plate having low moisture permeability. Therefore, moisture is hard to enter into the solar cell module la from the plate 10 side. Thus, the light receiving surface 12a of the solar cell 12 and the portion located on the light receiving surface 12a side in the filler layer 13, each of which exerts a large influence on the output from the solar cell module 1a, are hard to be degraded. Accordingly, it is possible to further improve the weatherability of the solar cell module 1a.

In the present embodiment, particularly, the first filler layer 13a having high moisture permeability is not disposed, but the second filler layer 13b having low moisture permeability is disposed on the light receiving surface 12a side of the solar cell 12. Therefore, it is possible to further reduce moisture reaching the light receiving surface 12a of the solar cell 12. Thus, it is possible to more effectively prevent the degradation of the light receiving surface 12a of the solar cell 12. Accordingly, it is possible to further improve the weatherability of the solar cell module 1a.

Herein, the solar cell module 1a according to the present embodiment can be manufactured in accordance with a manufacturing method to be described below, for example.

First, one or a plurality of sheets containing, as a main component, polyethylene is disposed on the sheet 11 so as to form the second filler layer 13b. The plurality of solar cells 12 electrically connected to one another using the wiring members 14 is disposed thereon and, further, one or a plurality of sheets containing, as a main component, EVA is disposed thereon so as to form the first filler layer 13a. Finally, the plate 10 is laminated. The formed laminate is subjected to thermocompression bonding under an atmosphere of reduced pressure. Thus, the solar cell module 1a can be manufactured.

Different preferred embodiments of the present invention will be described below. In the following description, members having substantially common functions to those in the foregoing embodiment are denoted with common reference signs; therefore, the description thereof will not be given.

<<Second Embodiment>>

Fig. 2 is a schematic sectional view of a solar cell module 1b according to a second embodiment.

As illustrated in Fig. 2, in the second embodiment, a second filler layer 13b having low moisture permeability is provided to come into contact with both of a plate 10 and a sheet 11. Specifically, the second filler layer 13b is provided from the plate 10 to the sheet 11 in a lamination direction z at a peripheral edge of the solar cell module 1b. That is, the second filler layer 13b is provided outside the first filler layer 13a when being seen from the lamination direction z.

Herein, the solar cell module 1b according to the second embodiment can be manufactured in accordance with a substantially similar method to the manufacturing method described in the first embodiment in such a manner that an area of a sheet for forming the first filler layer 13a is set to be smaller than an area of a sheet for forming the second filler layer 13b, for example.

<<Third Embodiment>>

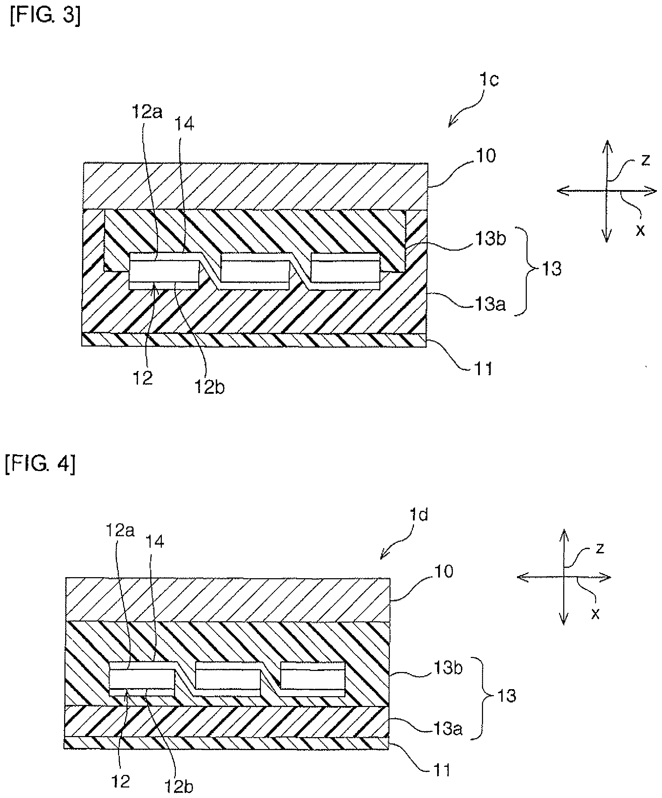

Fig. 3 is a schematic sectional view of a solar cell module 1c according to a third embodiment.

As illustrated in Fig. 3, in the third embodiment, a first filler layer 13a having fluidity which is low even at high temperature is provided to come into contact with both of a plate 10 and a sheet 11. Specifically, in the present embodiment, the first filler layer 13a is provided from the plate 10 to the sheet 11 in a lamination direction z at a peripheral edge of the solar cell module 1c. That is, the first filler layer 13a is placed outside the second filler layer 13b when being seen from the lamination direction z.

Herein, the solar cell module 1c according to the third embodiment can be manufactured in accordance with a substantially similar method to the manufacturing method described in the first embodiment in such a manner that an area of a sheet for forming the second filler layer 13b is set to be smaller than an area of a sheet for forming the first filler layer 13a, for example.

<<Fourth Embodiment>>

Fig. 4 is a schematic sectional view of a solar cell module Id according to a fourth embodiment.

In the first to third embodiments, the description is given of the example that the plurality of solar cells 12 is disposed on the boundary between the first filler layer 13a and the second filler layer 13b. On the other hand, in the fourth embodiment, as illustrated in Fig. 4, a second filler layer 13b is formed to come closer to a sheet 11 than a plurality of solar cells 12, and the solar cells 12 are disposed inside the second filler layer 13b. That is, the solar cell 12 is surrounded with the second filler layer 13b having low moisture permeability.

Herein, the solar cell module Id according to the fourth embodiment can be manufactured in accordance with a substantially similar method to the manufacturing method described in the first embodiment in such a manner that a sheet for forming the second filler layer 13b is interposed between a sheet for forming the first filler layer 13a and the solar cell 12, for example.

<<Fifth Embodiment>>

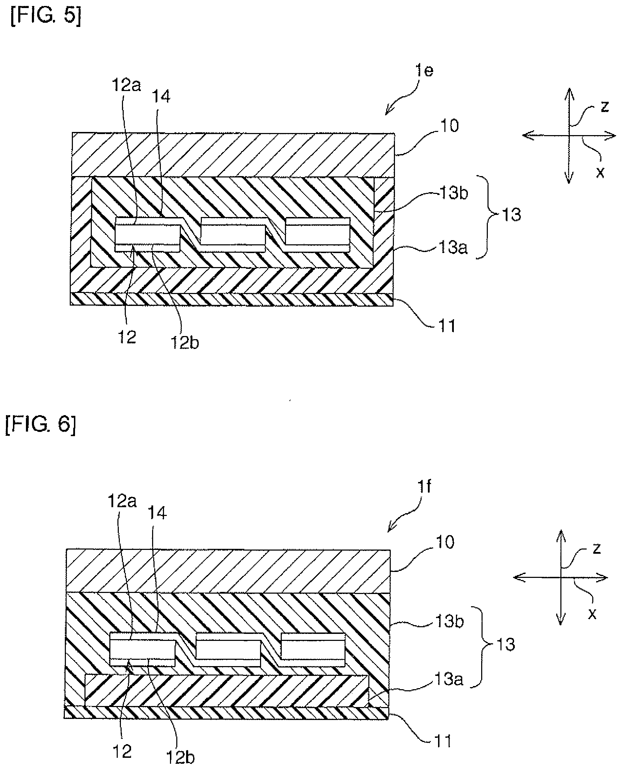

Fig. 5 is a schematic sectional view of a solar cell module le according to a fifth embodiment.

As illustrated in Fig. 5, the solar cell module 1e according to the present embodiment is different from the solar cell module Id according to the fourth embodiment in a point that a first filler layer 13a is provided from a plate 10 to a sheet 11 in a lamination direction z at a peripheral edge of the solar cell module 1e as in the third embodiment. In the present embodiment, therefore, the first filler layer 13a is placed outside the second filler layer 13b when being seen from the lamination direction z.

«Sixth Embodiment»

Fig. 6 is a schematic sectional view of a solar cell module 1f according to a sixth embodiment.

As illustrated in Fig. 6, the solar cell module If according to the present embodiment is different from the solar cell module 1d according to the fourth embodiment in a point that a second filler layer 13b is provided from a plate 10 to a sheet 11 in a lamination direction z at a peripheral edge of the solar cell module 1f as in the second embodiment. In the present embodiment, therefore, the second filler layer 13b is placed outside the first filler layer 13a when being seen from the lamination direction z.

<<Seventh Embodiment>>

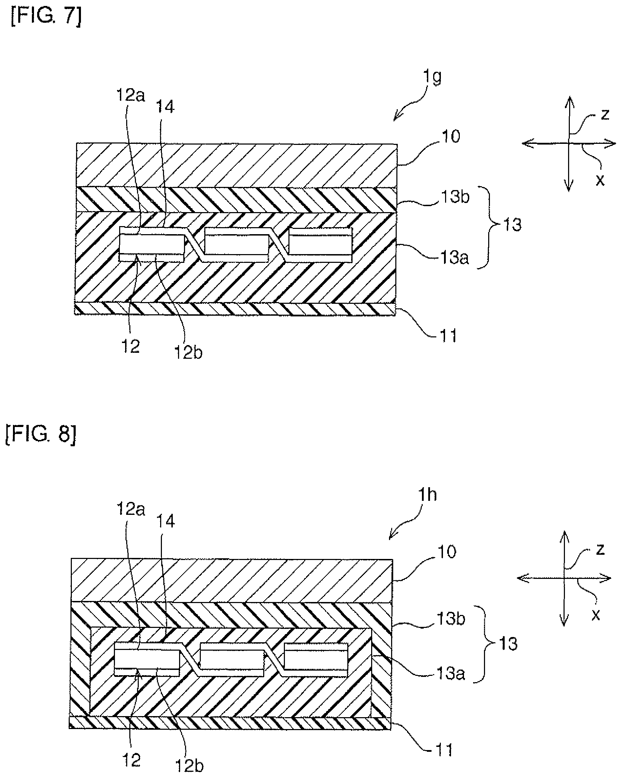

Fig. 7 is a schematic sectional view of a solar cell module 1g according to a seventh embodiment.

As illustrated in Fig. 7, the solar cell module 1g according to the present embodiment is different from the solar cell module 1a according to the first embodiment in a point that a first filler layer 13a is formed to come closer to a plate 10 than a plurality of solar cells 12 and the plurality of solar cells 12 is disposed inside the first filler layer 13a.

Herein, the solar cell module 1g according to the present embodiment can be manufactured in accordance with a substantially similar manufacturing method to the manufacturing method described in the first embodiment in such a manner that a sheet for forming the first filler layer 13a is disposed before the solar cell 12 is disposed on a sheet for forming a second filler layer 13b.

<<Eighth Embodiment>>

Fig. 8 is a schematic sectional view of a solar cell module 1h according to an eighth embodiment.

As illustrated in Fig. 8, the solar cell module 1h according to the eighth embodiment is different from the solar cell module 1g according to the seventh embodiment in a point that a second filler layer 13b is provided from a plate 10 to a sheet 11 in a lamination direction z at a peripheral edge of the solar cell module 1h as in the second and sixth embodiments. In the present embodiment, therefore, the second filler layer 13b is placed outside a first filler layer 13a when being seen from the lamination direction z.

<<Ninth Embodiment>>

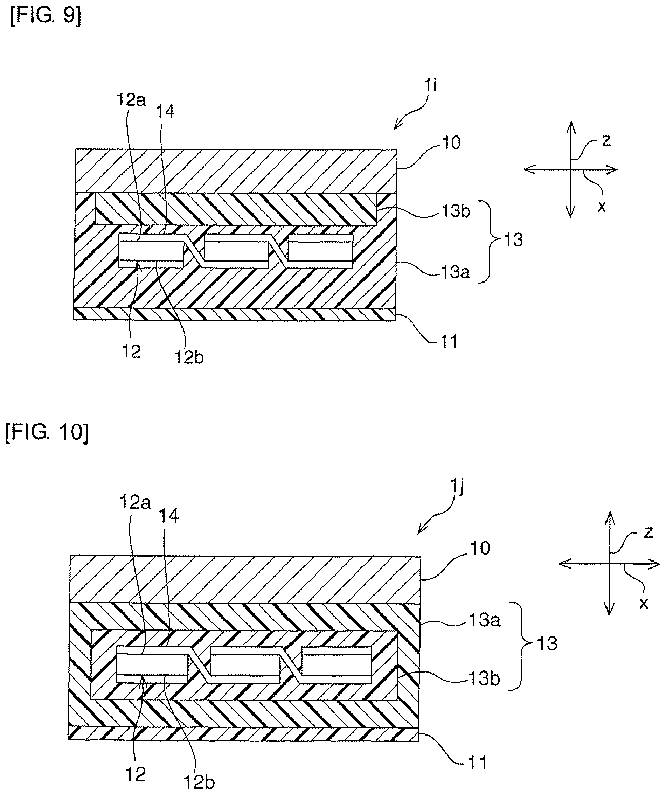

Fig. 9 is a schematic sectional view of a solar cell module 1i according to a ninth embodiment.

As illustrated in Fig. 9, the solar cell module 1i according to the ninth embodiment is different from the solar cell module 1g according to the seventh embodiment in a point that a first filler layer 13a is provided from a plate 10 to a sheet 11 in a lamination direction z at a peripheral edge of the solar cell module 1i as in the third and fifth embodiments. In the present embodiment, therefore, the first filler layer 13a is placed outside a second filler layer 13b when being seen from the lamination direction z.

<<Tenth to Twelfth Embodiments>>

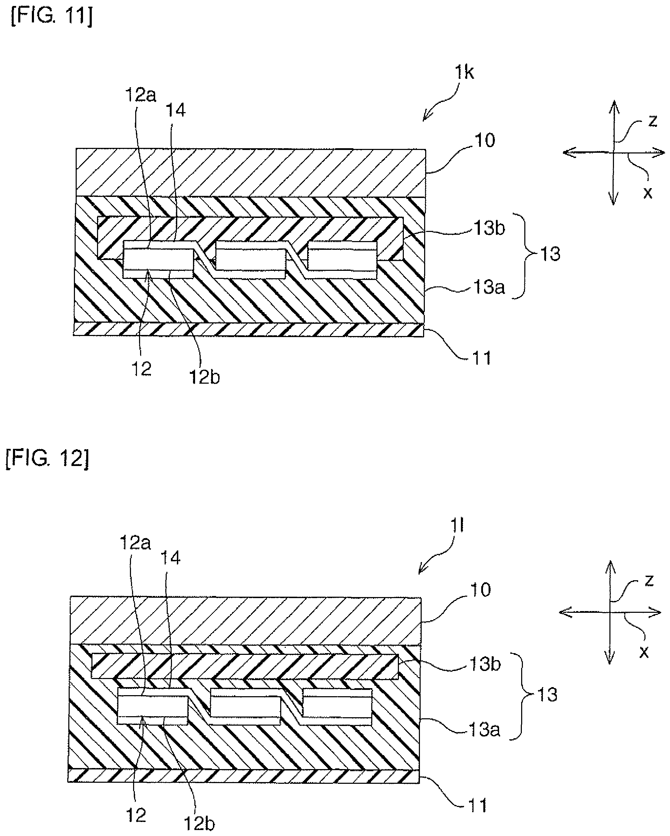

Fig. 10 is a schematic sectional view of a solar cell module 1j according to a tenth embodiment. Fig. 11 is a schematic sectional view of a solar cell module 1k according to an eleventh embodiment. Fig. 12 is a schematic sectional view of a solar cell module 1l according to a twelfth embodiment.

As illustrated in Figs. 10 to 12, in the tenth to twelfth embodiments, a first filler layer 13a is in contact with both of a plate 10 and a sheet 11. The first filler layer 13a is provided such that a second filler layer 13b is surrounded therewith.

As illustrated in Fig. 10, in the tenth embodiment, a plurality of solar cells 12 is disposed inside the second filler layer 13b.

As illustrated in Fig. 11, in the eleventh embodiment, a plurality of solar cells 12 is disposed on a boundary between the first filler layer 13a and the second filler layer 13b.

As illustrated in Fig. 12, in the twelfth embodiment, a plurality of solar cells 12 is disposed inside the first filler layer 13a.

Also in the solar cell modules 1b to 1l according to the second to twelfth embodiments, as in the solar cell module 1a according to the first embodiment, the first filler layer 13a having fluidity which is low at high temperature is provided to come into contact with the sheet 11 and the second filler layer 13b having low moisture permeability is provided. Therefore, it is possible to achieve both of excellent weatherability and excellent heat resistance.

Also in the second, third and eleventh embodiments, as in the first embodiment, the first filler layer 13a having fluidity which is low at high temperature is provided to come into contact with the plurality of solar cells 12. Accordingly, it is possible to realize more excellent heat resistance.

Also in the second to sixth embodiments, as in the first embodiment, the first filler layer 13a having high moisture permeability is not disposed, but the second filler layer 13b having low moisture permeability is disposed on the light receiving surface 12a side of the solar cell 12. Accordingly, it is possible to realize more excellent heat resistance.

In the fourth to sixth and tenth embodiments, the plurality of solar cells 12 is disposed inside the second filler layer 13b. That is, the plurality of solar cells 12 is surrounded with the second filler layer 13b having low moisture permeability. Therefore, it is possible to more effectively prevent moisture from reaching the plurality of solar cells 12. Thus, it is possible to more effectively prevent the degradation of the plurality of solar cells 12 due to the moisture. Accordingly, it is possible to realize more excellent weatherability.

In the seventh to ninth and twelfth embodiments, the plurality of solar cells 12 is disposed inside the first filler layer 13a. That is, the plurality of solar cells 12 is surrounded with the first filler layer 13a having fluidity which is low at high temperature. Therefore, the plurality of solar cells 12 is suitably protected by the first filler layer 13a even under an atmosphere of high temperature. Accordingly, it is possible to realize more excellent heat resistance.

In the third, fifth and ninth to twelfth embodiments, the first filler layer 13a having fluidity which is low at high temperature is provided to come into contact with both the plate 10 and the sheet 11. Therefore, it is possible to more effectively prevent the filler layer 13 from becoming deformed at high temperature. In the third, fifth and ninth to twelfth embodiments, particularly, the first filler layer 13a is placed outside the second filler layer 13b. Thus, it is possible to effectively prevent the second filler layer 13b having fluidity which is high at high temperature from being flown at high temperature. Accordingly, it is possible to realize more excellent heat resistance.

In the tenth to twelfth embodiments, particularly, the second filler layer 13b is surrounded with the first filler layer 13a. Therefore, it is possible to more effectively prevent the second filler layer 13b from being flown at high temperature. Accordingly, it is possible to realize more excellent heat resistance.

In the second, sixth and eighth embodiments, the second filler layer 13b having low moisture permeability is provided to come into contact with both the plate 10 and the sheet 11. Specifically, the second filler layer 13b is provided from the plate 10 to the sheet 11 in the lamination direction z at the peripheral edge of each of the solar cell modules 1b, If and 1h. Therefore, it is possible to effectively prevent moisture from entering into the solar cell modules 1b, 1f and 1h through the peripheral edges of the solar cell modules 1b, If and 1h. Accordingly, it is possible to realize more excellent weatherability.

In the second, third, fifth, sixth and eighth to twelfth embodiments, the boundary between the first filler layer 13a and the second filler layer 13b is not exposed at a side surface of the solar cell module. Thus, it is possible to reduce an amount of moisture entering into the solar cell module through the boundary between the first filler layer 13a and the second filler layer 13b as compared with the case where the boundary between the first filler layer 13a and the second filler layer 13b is exposed at the side surface of the solar cell module as described in the first embodiment and the like. Accordingly, it is possible to further improve the weatherability of the solar cell module.

<<Examples>>

(Non claimed example 1)

In the present non-claimed example, a solar cell module A1 having a similar configuration to that of the solar cell module 1a according to the first embodiment was prepared in accordance with the following procedure. First, an EVA sheet having a vinyl acetate content of 15% by mass and a thickness of 0.6 mm, a plurality of solar cells 12 electrically connected to one another using wiring members 14, an EVA sheet having a vinyl acetate content of 25% by mass and a thickness of 0.6 mm, and a sheet 11 were laminated in this order on a plate 10 formed from a glass plate. The resultant laminate was integrated by lamination and then was housed in a frame made of aluminum. Thus, the solar cell module was prepared. In the present example, a first filler layer 13a has a vinyl acetate content of 25% by mass. A second filler layer 13b has a vinyl acetate content of 15% by mass.

Herein, polyethylene terephthalate having a thickness of about 190 $\mu$m was used as the sheet 11. Moreover, a plurality of fingers mutually extending in parallel and two bus bars provided to be orthogonal to the finger and disposed to be mutually separated from each other in the direction of extension of the finger were provided as collector electrodes on both surfaces of the solar cell 12 used herein.

Next, the prepared solar cell module was subjected to a high temperature and high humidity test and a temperature cycle test based on JIS C8991:2004.

Specifically, the high temperature and high humidity test was conducted as follows. That is, the solar cell module was left for 1000 hours in a high temperature and high humidity bath having a temperature within a range of $85\pm2$°C and a relative humidity within a range of $85\pm5$%. Then, an output decrease ratio of the solar cell module before and after conducting the high temperature and high humidity test ((output after conducting high temperature and high humidity test)/(output before conducting high temperature and high humidity test)) was measured. Moreover, a resistance increase ratio between the two bus bars on the light receiving surface 12a before and after conducting the high temperature and high humidity test (((resistance after conducting high temperature and high humidity test)-(resistance before conducting high temperature and high humidity test))/(resistance before conducting high temperature and high humidity test)) was measured.

The temperature cycle test was conducted as follows. That is, in a state that a conduction monitoring device is connected to both terminals of the prepared solar cell module and an insulating property monitoring device is connected between one of the terminals of the solar cell module and the frame, a cycle of raising the temperature of the solar cell module from a temperature within a range of -40$\pm2$°C to a temperature within a range of 90$\pm2$°C at 100°C/hour, holding the temperature for 10 minutes, lowering the temperature to the temperature within the range of -40$\pm2$°C at 100°C/hour, holding the temperature for 10 minutes, and raising the temperature again to the temperature within the range of 90$\pm2$°C at 100°C/hour was performed 200 times. In this test, air around the solar cell module was circulated at 2 m/minute. In this test, moreover, the solar cell module was irradiated with light having an AM of 1.5 and an intensity of 100 mW/cm$^2$. Then, an output decrease ratio of the solar cell module before and after conducting the temperature cycle test ((output after conducting temperature cycle test)/(output before conducting temperature cycle test)) was measured.

The results are shown in Table 1 below.

(Non-claimed example 2)

A solar cell module A2 having a similar configuration to that in Example 1 was prepared except that the vinyl acetate content in the second filler layer 13b was set to 5% by mass, and was subjected to the high temperature and high humidity test and the temperature cycle test as in Example 1. The results are shown in Table 1 below.

(Claimed example 3)

A solar cell module A3 having a similar configuration to that in Example 1 was prepared except that the vinyl acetate content in the second filler layer 13b was set to 0% by mass, and was subjected to the high temperature and high humidity test and the temperature cycle test as in Example 1. That is, in the present example, the second filler layer 13b was made of polyethylene. The results are shown in Table 1 below.

(Comparative Example 1)

A solar cell module B1 having a similar configuration to that in Example 1 was prepared except that the vinyl acetate content in the second filler layer 13b was set to 25% by mass, and was subjected to the high temperature and high humidity test and the temperature cycle test as in Example 1. The results are shown in Table 1 below.

(Comparative Example 2)

A solar cell module B2 having a similar configuration to that in Example 1 was prepared except that the vinyl acetate content in each of the first filler layer 13a and the second filler layer 13b was set to 0% by mass, and was subjected to the high temperature and high humidity test and the temperature cycle test as in Example 1. The results are shown in Table 1 below.

Table 1

| | Vinyl acetate content | | | High temperature and high humidity test | | Temperature cycle test |
|---|---|---|---|---|---|---|
| | First filler layer (% by mass) | Second filler layer (% by mass) | First filler layer /second filler layer | Output decrease ratio (%) | Resistance increase ratio (%) | Output decrease ratio (%) |
| Solar cell module A1 | 25 | 15 | 1.67 | 1.2 | 1.0 | 0.1 |
| Solar cell module A2 | 25 | 5 | 5 | 1.0 | 1.0 | 0.2 |
| Solar cell module A3 | 25 | 0 | - | 0.2 | 0.3 | 0.1 |
| Solar cell module B1 | 25 | 25 | 1 | 1.5 | 1.1 | 0.1 |
| Solar cell module B2 | 0 | 0 | - | 0.2 | 0.2 | 0.8 |

As shown in Table 1 above, in the solar cell modules A1 to A3 wherein the vinyl acetate content in the second filler layer 13b is small and the vinyl acetate content in the first filler layer 13a is large, the output decrease ratio and resistance increase ratio resulting from the high temperature and high humidity test were small and the output decrease ratio resulting from the temperature cycle test was also small.

On the other hand, in the solar cell module B1 wherein the vinyl acetate contents in both the first filler layer 13a and the second filler layer 13b are large, the output decrease ratio resulting from the temperature cycle test was small, but the output decrease ratio and resistance increase ratio resulting from the high temperature and high humidity test were large.

In the solar cell module B2 wherein the vinyl acetate contents in both the first filler layer 13a and the second filler layer 13b are small, the output decrease ratio and resistance increase ratio resulting from the high temperature and high humidity test were small, but the output decrease ratio resulting from the temperature cycle test was large.

It is apparent from these results that it is possible to achieve both of excellent weatherability and excellent heat resistance in such a manner that the first filler layer 13a provided to come into contact with the sheet 11 contains, as a main component, EVA having a small vinyl acetate content or polyethylene containing no vinyl acetate unit and the second filler layer 13b contains, as a main component, EVA having a large vinyl acetate content.

Moreover, it is apparent from the comparison about the results of the high temperature and high humidity test conducted on the solar cell modules A1 to A3 that weatherability is further improved as the vinyl acetate content in the EVA contained in the second filler layer 13b is set to be smaller. It is apparent from this result that the vinyl acetate content in the EVA contained in the second filler layer 13b is preferably not more than 15% by mass, more preferably not more than 5% by mass. Moreover, it is apparent that the vinyl acetate content in the EVA contained in the first filler layer 13a is preferably not less than 1.5 times, more preferably not less than 5 times as large as the vinyl acetate content in the EVA contained in the second filler layer 13b.

The solar cell module A3 and the solar cell module B2, wherein the vinyl acetate content in the EVA contained in the second filler layer 13b is 0% by mass, were equal in weatherability to each other although they were different from each other with regard to the vinyl acetate content in the EVA contained in the first filler layer 13a. It is apparent from this result that the weatherability is mainly correlated with the vinyl acetate content in the EVA contained in the second filler layer 13b and therefore the weatherability does not change so much even when the vinyl acetate content in the EVA contained in the first filler layer 13a is changed.

The solar cell modules A1 to A3 and B1, wherein the vinyl acetate content in the EVA contained in the first filler layer 13a is 25% by mass, were equal in heat resistance to one another although they were different from one another with regard to the vinyl acetate content in the EVA contained in the second filler layer 13b. The heat resistance was degraded only in the solar cell module B2 wherein the vinyl acetate content in the EVA contained in the first filler layer 13a is 0% by mass. It is apparent from this result that the heat resistance is mainly correlated with the vinyl acetate content in the EVA contained in the first filler layer 13a and therefore the weatherability does not change so much even when the vinyl acetate content in the EVA contained in the second filler layer 13b is changed.

Reference Signs List

| | |
|---|---|
| 1a to 11 | Solar cell module |
| 10 | Plate |
| 11 | Sheet |
| 12 | Solar cell |
| 12a | Light receiving surface of solar cell |
| 12b | Rear surface of solar cell |
| 13 | Filler layer |
| 13a | First filler layer |
| 13b | Second filler layer |
| 14 | Wiring member |

**Claims**

1. A solar cell module comprising:

    a plate;
    a sheet opposed to the plate;
    a filler layer provided between the plate and the sheet; and
    a solar cell disposed inside the filler layer, wherein
    the filler layer is provided to come into contact with the sheet, and includes a first filler layer containing, as a main component, an ethylene-vinyl acetate copolymer, and a second filler layer containing, as a main component, polyethylene.

2. The solar cell module according to claim 1, wherein
the vinyl acetate content in the ethylene-vinyl acetate copolymer contained in the first filler layer is not less than 20% by mass.

3. The solar cell module according to claim 1 or 2, wherein

the first filler layer is in contact with the solar cell.

4. The solar cell module according to any one of claims 1 to 3, wherein
the solar cell is disposed between the first filler layer and the second filler layer.

5. The solar cell module according to claim 1 or 2, wherein
the solar cell is disposed inside the second filler layer.

6. The solar cell module according to claim 1 or 2, wherein
the solar cell is disposed inside the first filler layer.

7. The solar cell module according to claim 1 or 2, wherein
the first filler layer is provided to come into contact with both the plate and the sheet.

8. The solar cell module according to claim 1 or 2, wherein
the second filler layer is provided to come into contact with both the plate and the sheet.

9. The solar cell module according to claim 7, wherein
the first filler layer is disposed such that the second filler layer is surrounded therewith.

10. The solar cell module according to claim 1 or 2, wherein
the plate is a glass plate and the sheet is a resin sheet.

11. The solar cell module according to claim 10, wherein the solar cell receives light from the plate side.

12. The solar cell module according to any one of the previous claims, wherein the second filler layer contains an additive other than polyethylene, at a proportion of about 5% by mass or less.

13. The solar cell module according to any one of claims 1 to 12, wherein
the vinyl acetate content in the ethylene-vinyl acetate copolymer contained in the first filler layer is not more than 30% by mass.

14. The solar cell module according to any one of claims 1 to 13, wherein
the first filler layer contains, in a ratio within 5% by mass, a light stabilizer, or an ultraviolet absorber, or a silane modified resin.

15. The solar cell module according to any one of claims 1 to 14, wherein
the second filler layer contains, in a ratio within 5% by mass, a light stabilizer, or an ultraviolet absorber, or a silane modified resin.

**Patentansprüche**

1. Solarzellenmodul, das Folgendes umfasst:

eine Platte;
eine Folie, die der Platte gegenüber liegt;
eine Füllschicht, die zwischen der Platte und der Folie bereitgestellt ist; und
eine Solarzelle, die in der Füllschicht angeordnet ist, wobei die Füllschicht so bereitgestellt ist, dass sie mit der Folie in Kontakt kommt, und eine erste Füllschicht, die als Hauptkomponente ein Ethylenvinylacetat-Copolymer enthält, und eine zweite Füllschicht, die als Hauptkomponente Polyethylen enthält, umfasst.

2. Solarzellenmodul nach Anspruch 1, wobei der Vinylacetatgehalt im Ethylenvinylacetat-Copolymer, das in der ersten Füllschicht enthalten ist, nicht weniger als 20 Masse-% beträgt.

3. Solarzellenmodul nach Anspruch 1 oder 2, wobei die erste Füllschicht in Kontakt mit der Solarzelle ist.

4. Solarzellenmodul nach einem der Ansprüche 1 bis 3, wobei die Solarzelle zwischen der ersten Füllschicht und der zweiten Füllschicht angeordnet ist.

5. Solarzellenmodul nach Anspruch 1 oder 2, wobei die Solarzelle innerhalb der zweiten Füllschicht angeordnet ist.

6. Solarzellenmodul nach Anspruch 1 oder 2, wobei die Solarzelle innerhalb der ersten Füllschicht angeordnet ist.

7. Solarzellenmodul nach Anspruch 1 oder 2, wobei die erste Füllschicht bereitgestellt ist, um mit sowohl der Platte als auch der Folie in Kontakt zu kommen.

8. Solarzellenmodul nach Anspruch 1 oder 2, wobei die zweite Füllschicht bereitgestellt ist, um mit sowohl der Platte als auch der Folie in Kontakt zu kommen.

9. Solarzellenmodul nach Anspruch 7, wobei die erste Füllschicht so angeordnet ist, dass die zweite Füllschicht davon umgeben ist.

10. Solarzellenmodul nach Anspruch 1 oder 2, wobei die Platte eine Glasplatte und die Folie eine Harzfolie ist.

11. Solarzellenmodul nach Anspruch 10, wobei die Solarzelle Licht von der Plattenseite empfängt.

12. Solarzellenmodul nach einem der vorangegangenen Ansprüche, wobei die zweite Füllschicht einen Zusatzstoff, ausgenommen Polyethylen, in einem Anteil von etwa 5 Masse-% oder weniger enthält.

13. Solarzellenmodul nach einem der Ansprüche 1 bis 12, wobei der Vinylacetatgehalt im Ethylenvinylacetat-Copolymer, das in der ersten Füllschicht enthalten ist, nicht mehr als 30 Masse-% beträgt.

14. Solarzellenmodul nach einem der Ansprüche 1 bis 13, wobei die erste Füllschicht, in einem Anteil von höchstens 5 Masse-%, einen Lichtstabilisator oder ein Ultraviolettabsorptionsmittel oder ein Silan-modifiziertes Harz enthält.

15. Solarzellenmodul nach einem der Ansprüche 1 bis 14, wobei die zweite Füllschicht, in einem Anteil von höchstens 5 Masse-%, einen Lichtstabilisator oder ein Ultraviolettabsorptionsmittel oder ein Silan-modifiziertes Harz enthält.


**Revendications**

1. Module de cellule solaire comprenant :

   une plaque ;
   une feuille opposée à la plaque ;
   une couche de remplissage prévue entre la plaque et la feuille ; et
   une cellule solaire disposée à l'intérieur de la couche de charge, dans lequel
   la couche de charge est prévue pour venir en contact avec la feuille, et comprend une première couche de charge contenant, en tant que composant principal, un copolymère d'éthylène et d'acétate de vinyle, et une seconde couche de charge contenant, comme composant principal, du polyéthylène.

2. Module de cellule solaire selon la revendication 1, dans lequel
   la teneur en acétate de vinyle dans le copolymère d'éthylène et d'acétate de vinyle contenu dans la première couche de charge n'est pas inférieure à 20 % en masse.

3. Module de cellule solaire selon la revendication 1 ou 2, dans lequel
   la première couche de remplissage est en contact avec la cellule solaire.

4. Module de cellule solaire selon l'une quelconque des revendications 1 à 3, dans lequel
   la cellule solaire est disposée entre la première couche de remplissage et la seconde couche de remplissage.

5. Module de cellule solaire selon la revendication 1 ou 2, dans lequel
   la cellule solaire est disposée à l'intérieur de la seconde couche de remplissage.

6. Module de cellule solaire selon la revendication 1 ou 2, dans lequel

la cellule solaire est disposée à l'intérieur de la première couche de remplissage.

7. Module de cellule solaire selon la revendication 1 ou 2, dans lequel
   la première couche de remplissage est prévue pour entrer en contact à la fois avec la plaque et la feuille.

8. Module de cellule solaire selon la revendication 1 ou 2, dans lequel
   la seconde couche de remplissage est prévue pour entrer en contact à la fois avec la plaque et la feuille.

9. Module de cellule solaire selon la revendication 7, dans lequel
   la première couche de remplissage est disposée de sorte que la seconde couche de remplissage soit entourée de celle-ci.

10. Module de cellule solaire selon la revendication 1 ou 2, dans lequel
    la plaque est une plaque de verre et la feuille est une feuille de résine.

11. Module de cellule solaire selon la revendication 10, dans lequel
    la cellule solaire reçoit de la lumière provenant du côté de plaque.

12. Module de cellule solaire selon l'une quelconque des revendications précédentes, dans lequel la seconde couche de charge contient un additif autre que le polyéthylène, en une proportion d'environ 5 % en masse ou moins.

13. Module de cellule solaire selon l'une quelconque des revendications 1 à 12, dans lequel
    la teneur en acétate de vinyle du copolymère d'éthylène et d'acétate de vinyle contenu dans la première couche de charge ne dépasse pas 30 % en masse.

14. Module de cellule solaire selon l'une quelconque des revendications 1 à 13, dans lequel
    la première couche de charge contient, dans un rapport de moins de 5 % en masse, un stabilisateur de lumière, ou un absorbeur d'ultraviolets, ou une résine modifiée au silane.

15. Module de cellule solaire selon l'une quelconque des revendications 1 à 14, dans lequel
    la seconde couche de charge contient, dans un rapport de 5 % en masse au maximum, un stabilisateur de lumière, ou un absorbeur d'ultraviolets, ou une résine modifiée au silane.

[FIG. 1]

[FIG. 2]

[FIG. 3]

[FIG. 4]

[FIG. 5]

[FIG. 6]

[FIG. 7]

[FIG. 8]

[FIG. 9]

[FIG. 10]

[FIG. 11]

[FIG. 12]

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002039631 B
- JP 2005129926 B
- JP 2008235603 B
- JP 2005129926 A